# EUROPÄISCHE PATENTANMELDUNG

(11) **EP 3 629 680 A1**
(43) Veröffentlichungstag der Anmeldung: **01.04.2020**
(21) Anmeldenummer: 19200009.9
(22) Anmeldetag: 27.09.2019
(51) Int. Cl.: H05K 1/02, H05K 1/18

(54) **LEITERPLATTENVORRICHTUNG UND VERFAHREN ZUM HERSTELLEN EINER LEITERPLATTENVORRICHTUNG**

(30) Priorität: 28.09.2018 DE 102018123992
(71) Anmelder: KNORR-BREMSE Systeme für Nutzfahrzeuge GmbH, 80809 München (DE)
(72) Erfinder: HERGES, Michael, 80935 München (DE); EISENBERGER, Andreas, 72622 NÜRTINGEN (DE); WENNER, Maximilian, 71726 Benningen (DE); WINDISCH, Andreas, 82008 Unterhaching (DE)

(57) **Zusammenfassung**

Eine Leiterplattenvorrichtung (100) weist eine Leiterplatte (105) mit zumindest einem Kontaktbereich (110) mit einem Kontaktelement (115) zum elektrischen Kontaktieren eines Bauteils (120) und einem den Kontaktbereich (110) zumindest abschnittsweise von einem Restbereich (125) der Leiterplatte (105) freistellenden Freischnitt (130) auf.

Der Freischnitt (130) ist dazu ausgeformt, um im Betrieb der Leiterplattenvorrichtung (100) ein Entkoppeln des Kontaktbereichs (110) von dem Restbereich (125) der Leiterplatte (105) bezüglich zumindest einer Bewegungsrichtung des Kontaktbereichs (110) oder des Restbereichs (125) zu ermöglichen.

## Beschreibung

Der vorliegende Ansatz bezieht sich auf eine Leiterplattenvorrichtung und ein Verfahren zum Herstellen einer Leiterplattenvorrichtung.

Im Betrieb einer Leiterplatte können an oder zwischen den auf der Leiterplatte angeordneten Bauteilen oder Kontakten Bewegungen entstehen.

Vor diesem Hintergrund ist es die Aufgabe des vorliegenden Ansatzes eine verbesserte Leiterplattenvorrichtung und ein Verfahren zum Herstellen einer verbesserten Leiterplattenvorrichtung zu schaffen.

Diese Aufgabe wird durch eine Leiterplattenvorrichtung und ein Verfahren zum Herstellen einer Leiterplattenvorrichtung gemäß den Hauptansprüchen gelöst.

Die mit dem vorgestellten Ansatz erreichbaren Vorteile bestehen darin, dass eine Leiterplattenvorrichtung geschaffen wird, die voneinander zumindest teilweise mechanisch entkoppelte Bereiche aufweist. Somit kann einer der Bereiche vorteilhafterweise unbeeinflusst oder lediglich geringfügig beeinflusst von Vibrationen, Körperschall, Verspannungen oder anderen auftretenden Störfaktoren in dem anderen Bereich bleiben.

Eine Leiterplattenvorrichtung weist eine Leiterplatte mit zumindest einem Kontaktbereich mit einem Kontaktelement zum elektrischen Kontaktieren eines Bauteils und einem den Kontaktbereich zumindest abschnittsweise von einem Restbereich der Leiterplatte freistellenden Freischnitt auf. Der Freischnitt ist dazu ausgeformt, um im Betrieb der Leiterplattenvorrichtung ein Entkoppeln des Kontaktbereichs von dem Restbereich der Leiterplatte bezüglich zumindest einer Bewegungsrichtung des Kontaktbereichs oder des Restbereichs zu ermöglichen.

Der Freischnitt kann an einem Randbereich oder zumindest abschnittsweise um den Kontaktbereich herum verlaufend angeordnet sein. Beispielsweise kann der Freischnitt eine oder mehrere Durchgangsöffnungen von einer Oberseite der Leiterplatte zu einer parallel zu der Oberseite verlaufenden Unterseite der Leiterplatte ausformen. Somit kann der Freischnitt einen durchgängig durch die Leiterplatte verlaufenden Schnitt ausformen. Der Freischnitt kann eine Trennfuge ausformen. Im Bereich des Freischnitts kann der Kontaktbereich keine direkte Verbindung zu dem auf der gegenüberliegenden Seite des Freischnitts liegenden Restbereich der Leiterplatte aufweisen.

Die Leiterplattenvorrichtung kann gemäß einer Ausführungsform das Bauteil aufweisen, das an dem Kontaktelement elektrisch kontaktiert sein kann. Das Bauteil kann eine Sensoreinrichtung mit zumindest einem Sensor oder ein Aktor oder Aktuator oder Stecker oder eine integrierte Schaltung sein. Die Sensoreinrichtung kann als den Sensor einen Inertialsensor aufweisen. Das Kontaktelement kann als eine Lötfläche, auch Lötpad genannt, oder eine Stromschiene verstanden werden.

Der Freischnitt kann vorteilhafterweise dazu ausgeformt sein, um im Betrieb der Leiterplattenvorrichtung ein Entkoppeln des Kontaktbereichs von dem Restbereich bezüglich zumindest einer Bewegungsrichtung auf einer x-Achse und zusätzlich oder alternativ einer y-Achse und zusätzlich oder alternativ einer z-Achse des Kontaktbereichs oder des Restbereichs zu ermöglichen. Dies ermöglicht vorteilhafterweise eine entkoppelnde Wirkung bei einer Anwendung der Leiterplattenvorrichtung in einem eindimensional oder mehrdimensional bewegten, beispielsweise vibrierenden, Umfeld.

Beispielsweise kann der Kontaktbereich ein Plättchen und zumindest einen Steg mit einem Übergangsabschnitt zum Restbereich zum Verbinden des Kontaktbereichs mit dem Restbereich aufweisen. Das Plättchen kann rund, oder oval, oder eckig, beispielsweise rechteckig, ausgeformt sein. Eine Höhe des Kontaktbereichs kann einer Höhe des Restbereichs entsprechen. Der Freischnitt kann mit Ausnahme des Übergangsabschnitts um den Kontaktbereich herum verlaufen. Dies ermöglicht ein Bewegen oder Schwingen des Kontaktbereichs an dem Übergangsabschnitt entlang der y-Achse, also nach oben in Richtung der Oberseite der Leiterplatte und zusätzlich oder alternativ nach unten in Richtung der Unterseite der Leiterplatte.

Es ist weiterhin von Vorteil, wenn eine Erstreckungslänge des Stegs gemäß einer Ausführungsform länger ist, als ein Durchmesser des Plättchens. Dies erlaubt ein höheres und tieferes Bewegen oder Schwingen des Kontaktbereichs.

Alternativ kann aber auch eine Erstreckungslänge des Stegs im Wesentlichen, beispielsweise innerhalb eines Toleranzbereichs von bis zu zwanzig Prozent Abweichung, einer Breite des Freischnitts entsprechen. Dies erlaubt insbesondere auch mit mehreren und zusätzlich oder alternativ kürzeren Stegen ein Entkoppeln von geometrischen Verspannungen der Leiterplatte.

Der Steg kann zumindest abschnittsweise gerade und zusätzlich oder alternativ konkav und zusätzlich oder alternativ zumindest eine Windung aufweisend ausgeformt sein. Der Steg kann aber auch vollständig gerade oder konkav oder zumindest eine Windung aufweisend ausgeformt sein. Eine gerade Ausformung des Stegs erlaubt ein gerades Schwingen des Kontaktbereichs entlang einer Achse, eine konkave Ausformung erlaubt ein Entkoppeln des Kontaktbereichs von geometrischen Verspannungen der Leiterplatte und eine gewundene, beispielsweise eine S-förmig oder schlangenförmig gewundene Ausformung erlaubt eine dreidimensionale Bewegung des Kontaktbereichs um alle Achsen.

Gemäß einer vorteilhaften Ausführungsform weist der Steg zusätzlich oder alternativ eine Materialschwächung auf. Beispielsweise kann hierzu eine Höhe und zusätzlich oder alternativ eine Breite des Stegs in zumindest einem Stegabschnitt des Stegs geringer ausgeformt sein, als in einem übrigen Stegbereich. Die Materialschwächung kann in oder an oder quer durch den Steg angeformt sein. Eine solche Materialschwächung kann einen kürzeren Steg und somit eine Materialersparnis ermöglichen, wobei dennoch das Bewegen oder Schwingen entlang zumindest einer Achse in ausreichender Stärke gewährleistet ist.

Der Kontaktbereich kann zumindest einen weiteren Steg mit einem weiteren Übergangsabschnitt zum Restbereich zum Verbinden des Kontaktbereichs mit dem Restbereich aufweisen. Beispielsweise kann sich der weitere Steg von einer dem Steg gegenüberliegenden Seite des Plättchens weg erstreckt. Dies ermöglicht ein Entkoppeln des Kontaktbereichs von geometrischen Verspannungen der Leiterplatte und ein Drehen des Kontaktbereichs um die z-Achse, also ein schräges Kippen des Kontaktbereichs gegenüber der Oberseite und der Unterseite der Leiterplatte.

Auch kann der Kontaktbereich zumindest einen zusätzlichen Steg mit einem zusätzlichen Übergangsabschnitt zum Restbereich zum Verbinden des Kontaktbereichs mit dem Restbereich aufweisen. Auch eine solche Variante ermöglicht ein Entkoppeln des Kontaktbereichs von geometrischen Verspannungen der Leiterplatte. Mit somit insgesamt drei Stegen ist dabei eine besonders stabile Befestigung an dem Restbereich der Leiterplatte gewährleistet.

Von Vorteil ist es weiterhin, wenn die Leiterplattenvorrichtung zumindest eine an zumindest einem Freischnittabschnitt des Freischnitts angebrachte Dämpfungsmasse aufweist. Die Dämpfungsmasse kann auf oder in dem Freischnittabschnitt, beispielsweise zwischen dem Kontaktbereich und dem Restbereich angeordnet, beispielsweise eingefüllt oder eingespritzt, angeordnet sein. Bei einem Bewegen der Leiterplatte kann die Dämpfungsmasse, beispielsweise in Form von Silikon, Vibrationen oder Schwingungen zwischen dem Kontaktbereich und dem Restbereich dämpfen oder sogar verhindern.

Der Freischnitt kann gefräst, lasergeschnitten, wasserstrahlgeschnitten, gestanzt und zusätzlich oder alternativ gesägt ausgeformt sein. Der Freischnitt kann somit durch ein materialabtragendes Verfahren hergestellt sein.

Ein Verfahren zum Herstellen einer Leiterplattenvorrichtung umfasst einen Schritt des Bereitstellens und einen Schritt des Erzeugens. Im Schritt des Bereitstellens wird eine Leiterplatte mit zumindest einem Kontaktbereich mit einem Kontaktelement zum elektrischen Kontaktieren eines Bauteils bereitgestellt. Im Schritt des Erzeugens wird ein den Kontaktbereich zumindest abschnittsweise von einem Restbereich der Leiterplatte freistellender Freischnitt erzeugt, der dazu ausgeformt ist, um im Betrieb der Leiterplattenvorrichtung ein Entkoppeln des Kontaktbereichs von dem Restbereich der Leiterplatte bezüglich zumindest einer Bewegungsrichtung des Kontaktbereichs oder des Restbereichs zu ermöglichen. Beispielsweise kann der Freischnitt in einem oder mehreren Verfahrensschritten in oder durch die Leiterplatte gefräst, lasergeschnitten, wasserstrahlgeschnitten, gestanzt und zusätzlich oder alternativ gesägt ausgeformt werden.

Ausführungsbeispiele des hier vorgestellten Ansatzes werden in der nachfolgenden Beschreibung mit Bezug zu den Figuren näher erläutert. Es zeigen:
Fig. 1 bis 2 je eine schematische Darstellung einer Leiterplattenvorrichtung gemäß einem Ausführungsbeispiel;
Fig. 3 eine schematische Darstellung einer Materialschwächung einer Leiterplattenvorrichtung gemäß einem Ausführungsbeispiel;
Fig. 4 eine schematische Darstellung einer Leiterplattenvorrichtung gemäß einem Ausführungsbeispiel;
Fig. 5 eine schematische Darstellung einer Materialschwächung einer Leiterplattenvorrichtung gemäß einem Ausführungsbeispiel;
Fig. 6 bis 13 je eine schematische Darstellung einer Leiterplattenvorrichtung gemäß einem Ausführungsbeispiel;
Fig. 14 eine schematische Darstellung eines Fahrzeugs mit einer Leiterplattenvorrichtung gemäß einem Ausführungsbeispiel; und
Fig. 15 ein Ablaufdiagramm eines Verfahrens zum Herstellen einer Leiterplattenvorrichtung gemäß einem Ausführungsbeispiel.

In der nachfolgenden Beschreibung günstiger Ausführungsbeispiele des vorliegenden Ansatzes werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

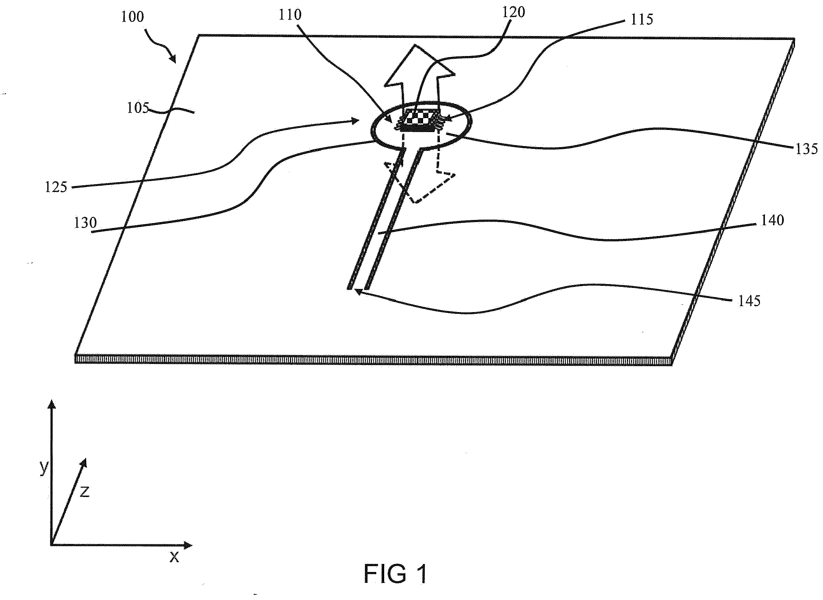

**Fig. 1** zeigt eine schematische Darstellung einer Leiterplattenvorrichtung 100 gemäß einem Ausführungsbeispiel.

Die Leiterplattenvorrichtung 100 weist eine Leiterplatte 105 mit zumindest einem Kontaktbereich 110 mit zumindest einem Kontaktelement 115 zum elektrischen Kontaktieren eines Bauteils 120 auf. Ferner weist die Leiterplatte 105 einen den Kontaktbereich 115 zumindest abschnittsweise von einem Restbereich 125 der Leiterplatte 105 freistellenden Freischnitt 130 auf. Der Freischnitt 130 ist dazu ausgeformt, um im Betrieb der Leiterplattenvorrichtung 100 ein Entkoppeln des Kontaktbereichs 110 von dem Restbereich 125 der Leiterplatte 105 bezüglich zumindest einer Bewegungsrichtung des Kontaktbereichs 110 oder des Restbereichs 125 zu ermöglichen.

Gemäß diesem Ausführungsbeispiel ist das Bauteil 120 an dem Kontaktelement 115 elektrisch kontaktiert. Bei dem Bauteil 120 handelt es sich gemäß diesem Ausführungsbeispiel um eine Sensoreinrichtung mit zumindest einem Sensor oder gemäß einem alternativen Ausführungsbeispiel um einen Aktor oder Aktuator oder Stecker oder eine integrierte Schaltung. Gemäß einem Ausführungsbeispiel weist das Bauteil 120 einen Inertialsensor auf, gemäß einem Ausführungsbeispiel einen ein- oder mehrachsigen Gierraten- und/oder Beschleunigungssensor, oder ein solcher Inertialsensor ist benachbart zu dem Bauteil 120 an dem oder einem weiteren Kontaktelement des Kontaktbereichs 110 kontaktiert. Ein solcher Inertialsensor ermöglicht vorteilhafterweise eine definiertere Einstellung der auf den Sensor übertragenen Frequenzen und eine Minimierung störender Frequenzen und mechanischer Spannungen. Gemäß einem Ausführungsbeispiel ist das Bauteil 120 ein oberflächenmontiertes Bauelement mit lotfähigen Anschlussflächen, die an einer Mehrzahl von Kontaktelementen 115 angelötet sind.

Gemäß einem alternativen Ausführungsbeispiel weist das Bauteil 120 zusätzlich oder alternativ einen Aktuator in Form eines Magnetventils und/oder eines Elektromotors auf oder aber das Bauteil 120 weist einen Anschluss zu einem Magnetventil und/oder einem Elektromotor auf. Gemäß dem alternativen Ausführungsbeispiel ist ein geringerer Eintrag von Schwingungen und/oder Verspannungen vom Aktuator zur Leiterplatte 105 oder zum Restbereich 125 der Leiterplatte 105 ermöglicht.

Gemäß einem Ausführungsbeispiel ist das Bauteil 120 starr mit dem Kontaktbereich 110 gekoppelt. Beispielsweise ist zumindest ein Kontaktfläche des Bauteils 120 über eine Lötverbindung mit dem als weitere Kontaktfläche ausgeformten Kontaktelement 115 verbunden. Wenn das Kontaktelement 115 als ein Teil eines Steckers ausgeformt ist, kann das Bauteil 120 über eine Steckverbindung mit dem Kontaktbereich 110 gekoppelt sein. Gemäß einem Ausführungsbeispiel ist das Bauteil 120 zusätzlich zu einer mechanischen und elektrischen Kontaktierung mit dem Kontaktelement 115 über eine rein mechanische Verbindung mit dem Kontaktbereich 110 verbunden.

Der Freischnitt 130 ist gemäß diesem Ausführungsbeispiel dazu ausgeformt, um im Betrieb der Leiterplattenvorrichtung 100 ein Entkoppeln des Kontaktbereichs 110 von dem Restbereich 125 bezüglich zumindest einer Bewegungsrichtung auf einer x-Achse und/oder einer y-Achse und/oder einer z-Achse des Kontaktbereichs 110 oder des Restbereichs 125 zu ermöglichen. Der Kontaktbereich 110 weist gemäß diesem Ausführungsbeispiel ein Plättchen 135 und zumindest einen Steg 140 mit einem Übergangsabschnitt 145 zum Restbereich 125 auf. Der Übergangsabschnitt 145 verbindet gemäß diesem Ausführungsbeispiel den Kontaktbereich 110 mit dem Restbereich 125. Das Bauteil 120 ist gemäß diesem Ausführungsbeispiel auf dem Plättchen 135 angeordnet, gemäß diesem Ausführungsbeispiel mittig auf dem Plättchen 135. Der Freischnitt 130 verläuft gemäß diesem Ausführungsbeispiel mit Ausnahme des Übergangsabschnitts 145 um den Kontaktbereich110 herum. Der Kontaktbereich 110 ist in einem hier gezeigten Ruhezustand der Leiterplatte 105 bündig in einer Ebene des Restbereichs 125 aufgenommen und lediglich durch den Freischnitt 130 mechanisch von dem Restbereich 125 getrennt. Der Kontaktbereich 110 kann auch als ein weich gekoppelter Bereich der Leiterplatte 105 bezeichnet werden. Der Steg 140 erstreckt sich gemäß diesem Ausführungsbeispiel einstückig von dem Plättchen 135 weg und geht durch den Übergangsabschnitt 145 einstückig in den Restabschnitt 125 der Leiterplatte 105 über. Der Steg 140 kann demnach auch als ein Verbindungssteg bezeichnet werden. Das Plättchen 135 ist gemäß diesem Ausführungsbeispiel rund ausgeformt. Gemäß einem alternativen Ausführungsbeispiel weist das Plättchen 135 eine beliebige andere Form auf. Eine Erstreckungslänge des Stegs 140 weg von dem Plättchen 135 ist gemäß diesem Ausführungsbeispiel länger, als ein Durchmesser des Plättchens 135. Gemäß diesem Ausführungsbeispiel ist die Erstreckungslänge des Stegs 140 kürzer als eine doppelte Länge des Durchmessers des Plättchens 135. Eine Breite des Stegs 140 entspricht gemäß diesem Ausführungsbeispiel weniger als einem Zehntel des Durchmessers des Plättchens 135. Der Steg 140 ist gemäß einem Ausführungsbeispiel zumindest abschnittsweise, gemäß diesem Ausführungsbeispiel vollständig, gerade ausgeformt.

Im Folgenden werden Ausführungsbeispiele der Leiterplattenvorrichtung 100 noch einmal mit anderen Worten genauer beschreiben:
Bei der hier vorgestellten Leiterplattenvorrichtung 100 ist vorteilhafterweise zumindest ein kritisches Bauteil 120 weich montiert. Gemäß einem Ausführungsbeispiel handelt es sich bei dem Bauteil 120 um ein Magnetventil, eine Steckverbindung oder ein anderes schweres Bauteil, das auf der Leiterplatte 105, auch Platine genannt, platziert ist oder werden soll, oder das anderweitig mechanisch mit der Leiterplatte 105 gekoppelt ist oder werden soll. Gemäß einem Ausführungsbeispiel handelt es sich bei dem Bauteil 120 um ein Befestigungselement der Leiterplatte 120, das störende Vibrationen oder Körperschall in die Leiterplatte 105 übertragen oder die Leiterplatte 105 unter mechanische Spannung setzen oder sogar verbiegen kann. Gemäß einem Ausführungsbeispiel ist das als Sensor ausgeformte Bauteil 120 empfindlich gegen mechanische Einflüsse wie Vibrationen, Körperschall oder Verspannungen der Leiterplatte 105 zwischen seinen Lötpunkten oder unter einer Auflagefläche des Bauteils 120. Dank der hier vorgestellten Leiterplattenvorrichtung 100 ist eine Möglichkeit gefunden, die Einleitung solcher Störungen in die Leiterplatte 105 oder die Auswirkungen von solchen in der Leiterplatte 105 vorhandenen Störungen auf empfindliche Bauteile 120 oder Bauelemente zu verhindern.

Der Bereich der Leiterplatte 105, der mit einem Störungen in die Leiterplatte 105 einleitenden Bauteil 120 verbunden ist oder auf dem empfindliche Bauteile 120 montiert sind, ist hierzu durch einen teilweise Freischnitt 130 vom Rest der Leiterplatte 105 entkoppelt, sodass sich eine mechanisch elastische Verbindung mit dem Rest der Leiterplatte 105 ergibt. Dadurch ist der Teil der Leiterplatte 105, auf dem sich das kritische Bauteil 120 befindet, in einer oder mehreren Richtungen mechanisch weich an den Rest der Leiterplatte 105 angebunden und kann sich in Grenzen gegenüber diesem Rest bewegen. Dabei ist darauf geachtet, dass sich durch die weiche Anbindung keine störenden Resonanzen einstellen.

Vorteilhafterweise ist die hier vorgestellte Leiterplattenvorrichtung 100 einfach herstellbar. Gemäß einem Ausführungsbeispiel ist die Leiterplattenvorrichtung 100 durch ein Herstellungsverfahren mit zumindest einem Schritt des Fräsens, Laserschneidens, Wasserstrahlschneidens, Stanzens und/oder Sägens herstellbar. Es ist kein gesondertes Lötverfahren für das Bauteil 120 nötig. Auch sind keine zusätzlichen Teile nötig. Elastizitäten sind richtungsabhängig einfach einstellbar. Der Kontaktbereich 110 oder zumindest das Plättchen 135 ist gemäß diesem Ausführungsbeispiel eindimensional verschiebeweich in y-Richtung, sodass sich das Plättchen 135 relativ zu der Leiterplatte 105 in y-Richtung bewegen kann, sodass eine weiche Montage des Bauteils 120 relisiert ist.

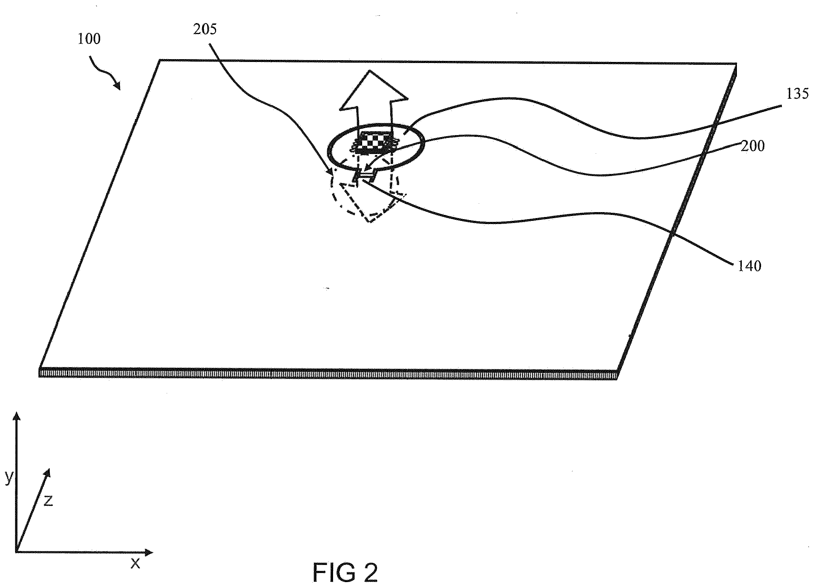

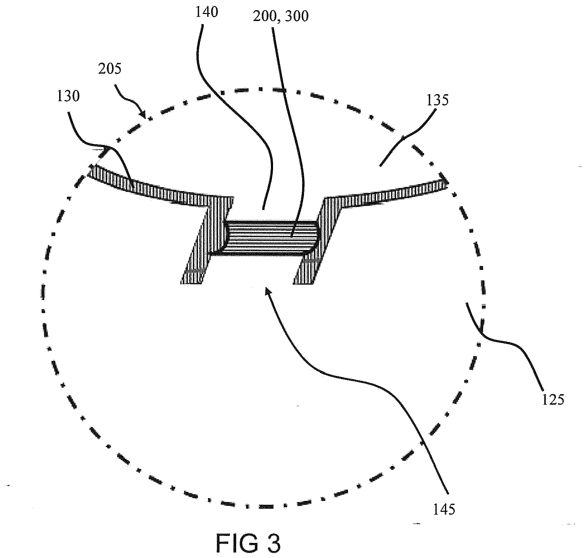

**Fig. 2** zeigt eine schematische Darstellung einer Leiterplattenvorrichtung 100 gemäß einem Ausführungsbeispiel. Dabei kann es sich um die anhand von Fig. 1 beschriebene Leiterplattenvorrichtungen 100 handeln, mit dem Unterschied, dass die Erstreckungslänge des Stegs 140 kürzer ausgeformt ist. Der Steg 140 weist gemäß diesem Ausführungsbeispiel zusätzlich oder alternativ eine optionale Materialschwächung 200 auf. Die Erstreckungslänge des Stegs 140 ist gemäß diesem Ausführungsbeispiel kürzer als eine Hälfte des Durchmessers des Plättchens 135 und/oder sogar kürzer als ein Viertel des Durchmessers des Plättchens 135. Eine vergrößerte Detailansicht eines Ausschnitts 205 mit der Materialschwächung 200 ist in Fig. 3 dargestellt und beschrieben. Der Kontaktbereich oder zumindest das Plättchen 135 ist gemäß diesem Ausführungsbeispiel eindimensional verschiebeweich in y-Richtung, wobei der Kontaktbereich gegenüber der in Fig. 1 gezeigten Variante flächenminimiert ist.

**Fig. 3** zeigt eine schematische Darstellung einer Materialschwächung 200 einer Leiterplattenvorrichtung gemäß einem Ausführungsbeispiel. Dabei handelt es sich um eine vergrößerte Detailansicht des in Fig. 2 skizzierten Ausschnitts 205 der Leiterplattenvorrichtung mit der Materialschwächung 200. Die Materialschwächung 200 ist gemäß diesem Ausführungsbeispiel mittig in dem Steg 140 und/oder quer zu einer sich von dem Plättchen 135 weg erstreckenden Erstreckungsrichtung des Stegs 140 verlaufend angeordnet. Die Materialschwächung 200 ist gemäß diesem Ausführungsbeispiel in Form einer geringeren Höhe und/oder Breite des Stegs 140 in zumindest einem Stegabschnitt 300 des Stegs 140 realisiert, als in einem übrigen Stegbereich. Gemäß diesem Ausführungsbeispiel weist der Stegabschnitt 300 eine geringere Höhe auf, als der übrige Stegbereich des Stegs 140. Die geringere Höhe ist gemäß diesem Ausführungsbeispiel als eine gewölbte Ausnehmung in zumindest eine Oberfläche und/oder eine gegenüberliegende Oberfläche des Stegabschnitts 300 realisiert. Gemäß diesem Ausführungsbeispiel verläuft die Materialschwächung 200 von einer Seite des Stegs 140 bis zu einer gegenüberliegenden weiteren Seite des Stegs 140. Die Materialschwächung 200 ermöglicht einen kürzeren Steg 140 und somit einen geringeren Platzbedarf. Anders ausgedrückt ist eine Elastizität des Stegs 140 gemäß diesem Ausführungsbeispiel erhöht durch eine lokale Reduzierung einer Materialstärke des Stegs 140 in y-Richtung.

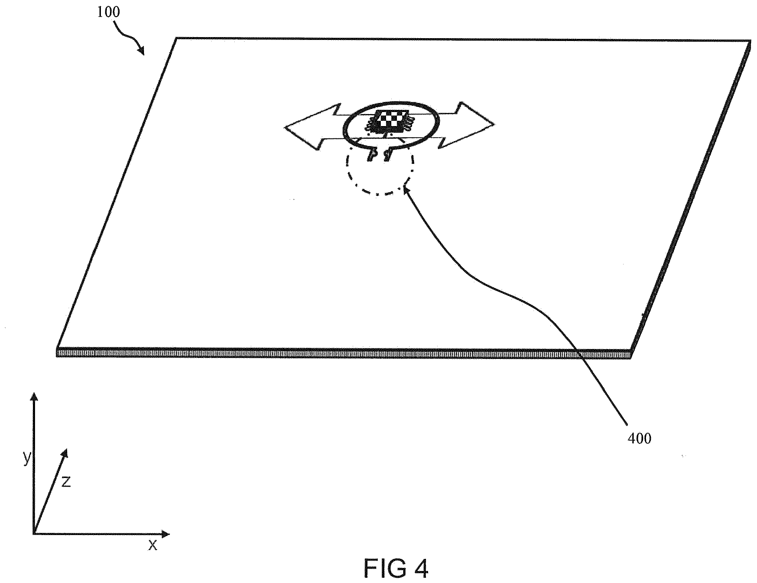

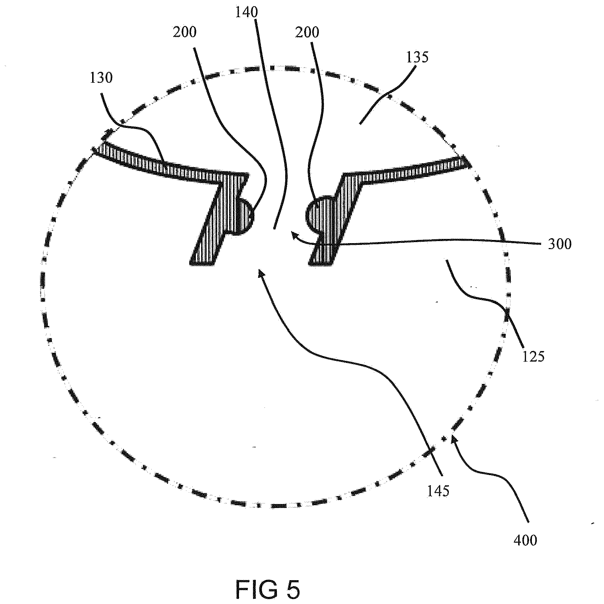

**Fig. 4** zeigt eine schematische Darstellung einer Leiterplattenvorrichtung 100 gemäß einem Ausführungsbeispiel. Dabei kann es sich um die anhand von Fig. 2 beschriebene Leiterplattenvorrichtungen 100 handeln, mit dem Unterschied, dass die Materialschwächung 200 gemäß diesem Ausführungsbeispiel in Form einer geringeren Breite des Stegabschnitts 300 gegenüber dem übrigen Stegbereich des Stegs 140 realisiert ist. Eine vergrößerte Detailansicht eines weiteren Ausschnitts 400 mit der Materialschwächung 200 ist in Fig. 5 dargestellt und beschrieben.

**Fig. 5** zeigt eine schematische Darstellung einer Materialschwächung 200 einer Leiterplattenvorrichtung gemäß einem Ausführungsbeispiel. Dabei handelt es sich um eine vergrößerte Detailansicht des in Fig. 4 skizzierten weiteren Ausschnitts 400 der Leiterplattenvorrichtung mit der Materialschwächung 200. Die geringere Breite ist gemäß diesem Ausführungsbeispiel als zumindest eine gewölbte Ausnehmung in eine Seitenwand und/oder eine gegenüberliegende Seitenwand des Stegabschnitts 300 realisiert. Der Kontaktbereich oder zumindest das Plättchen 135 ist gemäß diesem Ausführungsbeispiel eindimensional verschiebeweich in x-Richtung, wobei der Kontaktbereich aufgrund des kurzen Stegs 140 flächenminimiert ist. Die Elastizität des Stegs 140 ist gemäß diesem Ausführungsbeispiel durch eine lokale Reduzierung einer Materialstärke des Stegs 140 in x-Richtung erhöht.

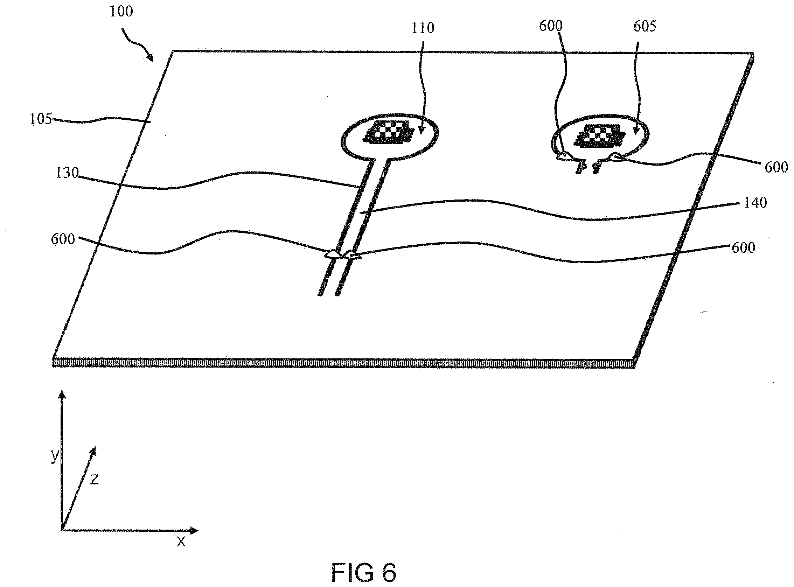

**Fig. 6** zeigt eine schematische Darstellung einer Leiterplattenvorrichtung 100 gemäß einem Ausführungsbeispiel. Dabei kann es sich um die anhand von Fig. 1 beschriebene Leiterplattenvorrichtungen 100 handeln, mit dem Unterschied, dass die Leiterplattenvorrichtungen 100 zumindest eine an zumindest einem Freischnittabschnitt des Freischnitts 130 angebrachte Dämpfungsmasse 600 aufweist. Gemäß diesem Ausführungsbeispiel sind zwei der Dämpfungsmassen 600 einander gegenüberliegend auf zwei gegenüberliegenden Seiten des Stegs 140 je zwischen dem Steg 140 und dem Restbereich der Leiterplatte 105 angeordnet sind. Somit überbrücken die Dämpfungsmassen 600 den Freischnitt 130. Gemäß diesem Ausführungsbeispiel sind die Dämpfungsmassen 600 näher an dem Übergangsabschnitt, als an dem Plättchen angeordnet.

Optional weist die Leiterplattenvorrichtung 100 gemäß diesem Ausführungsbeispiel einen weiteren Kontaktbereich 605 auf, der lediglich beispielhaft wie der in den Figuren 4 bis 5 beschriebene Kontaktbereich ausgeformt ist. Der Freischnitt des weiteren Kontaktbereichs 605 ist gemäß diesem Ausführungsbeispiel ebenfalls oder alternativ an zumindest einem Freischnittabschnitt mit einer Dämpfungsmasse 600 versehen. Gemäß diesem Ausführungsbeispiel weist der Freischnitt des weiteren Kontaktbereichs 605 zwei der Dämpfungsmassen 600 auf, die gemäß diesem Ausführungsbeispiel benachbart zu dem Steg des weiteren Kontaktbereichs 605 auf zwei gegenüberliegenden Seiten des Stegs des weiteren Kontaktbereichs 605 je zwischen dem Plättchen des weiteren Kontaktbereichs 605 und dem Restbereich der Leiterplatte angeordnet sind.

Gemäß einem Ausführungsbeispiel sind entsprechende Dämpfungsmassen 600 entsprechend oder ähnlich der beschriebenen Anordnung an dem Kontaktbereich 110 und/oder dem weiteren Kontaktbereich 605, an einem der Kontaktbereiche einer Leiterplattenvorrichtung angeformt, welche in einer der folgenden Figuren beschrieben sind.

Durch zumindest eine teilweise Überbrückung des Freischnitts 130 in Form einer Trennfuge an zumindest einer geeigneten Stelle oder geeigneten Stellen durch die Dämpfungsmasse 600 ist vorteilhafterweise eine Dämpfung ermöglicht. Die Dämpfungsmassen 600 weisen gemäß diesem Ausführungsbeispiel zumindest eine dämpfende Substanz wie Silikon, Schaumstoff und/oder Gummi auf. Somit ist im Betrieb der Leiterplattenvorrichtung 100 eine definiertere Dämpfung sowie eine Vermeidung von Resonanzen sichergestellt.

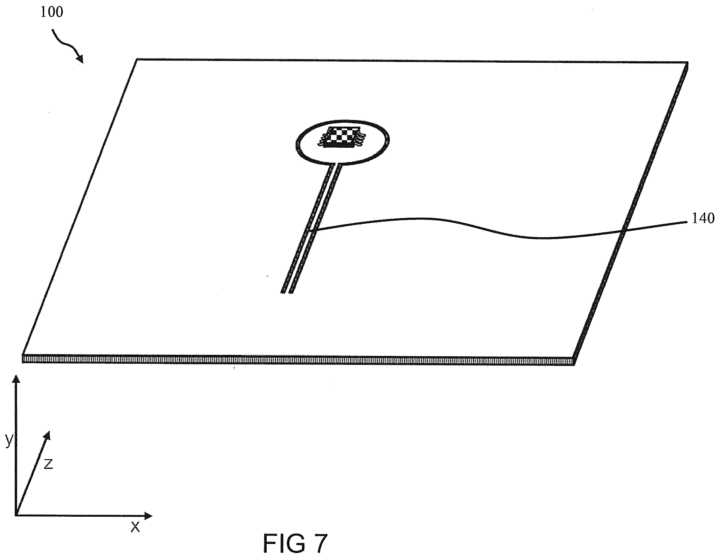

**Fig. 7** zeigt eine schematische Darstellung einer Leiterplattenvorrichtung 100 gemäß einem Ausführungsbeispiel. Dabei kann es sich um die anhand von Fig. 1 beschriebene Leiterplattenvorrichtungen 100 handeln, mit dem Unterschied, dass der Steg 140 gemäß diesem Ausführungsbeispiel schmaler ausgeformt ist. Eine Breite des Stegs 140 ist gemäß diesem Ausführungsbeispiel schmaler, als ein Zwanzigstel des Durchmessers des Plättchens. Der Kontaktbereich 110 oder zumindest das Plättchen 135 ist gemäß diesem Ausführungsbeispiel zweidimensional verschiebeweich in x- und y-Richtung sowie drehweich um die z-Achse.

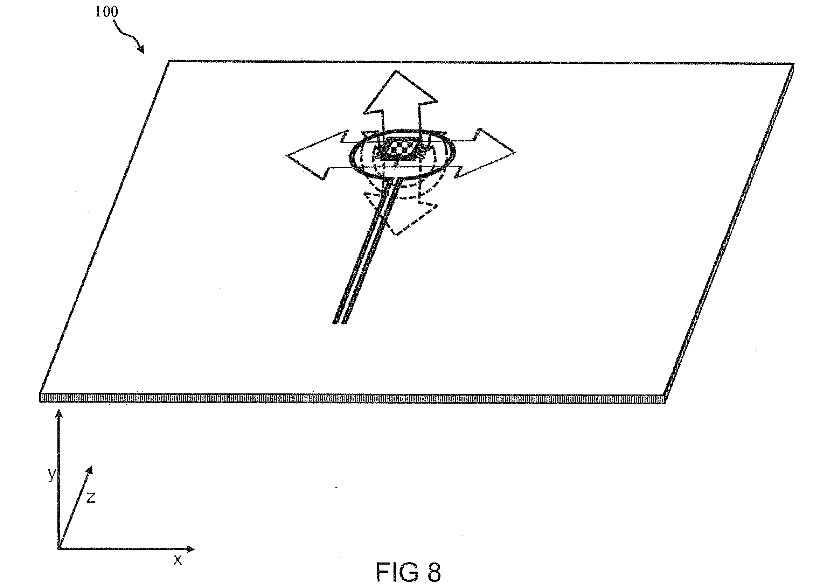

**Fig. 8** zeigt eine schematische Darstellung einer Leiterplattenvorrichtung 100 gemäß einem Ausführungsbeispiel. Dabei handelt es sich um die anhand von Fig. 7 beschriebene Leiterplattenvorrichtung 100, in der Pfeile dargestellt sind, welche die möglichen Bewegungen des Plättchens veranschaulichen. Dabei sind insbesondere Bewegungen in x- und y-Richtung und Kombinationen davon möglich.

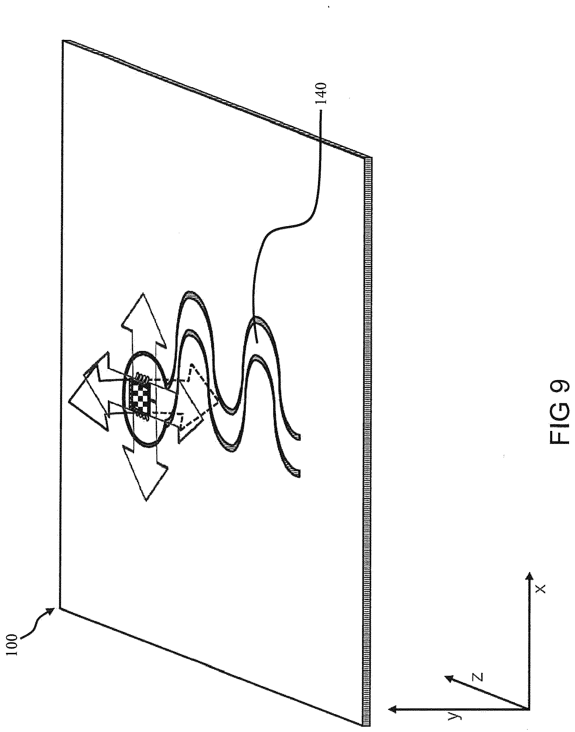

**Fig. 9** zeigt eine schematische Darstellung einer Leiterplattenvorrichtung 100 gemäß einem Ausführungsbeispiel. Dabei kann es sich um eine der anhand einer der Figuren 1, 6, 7 oder 8 beschriebenen Leiterplattenvorrichtungen 100 handeln, mit dem Unterschied, dass der Steg 140 gemäß diesem Ausführungsbeispiel zumindest eine Windung aufweist. Der Steg 140 weist gemäß diesem Ausführungsbeispiel mehrere s-förmig geschwungene Windungen auf. Der Kontaktbereich oder zumindest das Plättchen ist gemäß diesem Ausführungsbeispiel dreidimensional verschiebeweich und drehweich um alle Achsen.

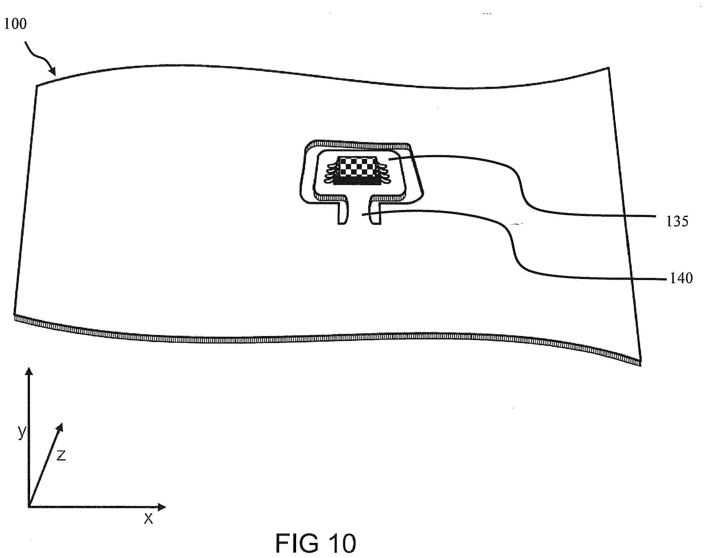

**Fig. 10** zeigt eine schematische Darstellung einer Leiterplattenvorrichtung 100 gemäß einem Ausführungsbeispiel. Dabei kann es sich um eine der anhand einer der vorangegangenen Figuren beschriebenen Leiterplattenvorrichtungen 100 handeln, mit dem Unterschied, dass das Plättchen 135 gemäß diesem Ausführungsbeispiel rechteckig und/oder der Steg 140 zumindest abschnittsweise konkav ausgeformt ist. Die Ecken des rechteckig ausgeformten Plättchens 135 sind gemäß diesem Ausführungsbeispiel abgerundet ausgeformt. Gemäß diesem Ausführungsbeispiel ist der Steg 140 vollständig konkav ausgeformt. Der Kontaktbereich oder zumindest das Plättchen 135 ist gemäß diesem Ausführungsbeispiel von geometrischen Verspannungen der Leiterplatte oder zumindest des Restbereichs der Leiterplatte entkoppelt.

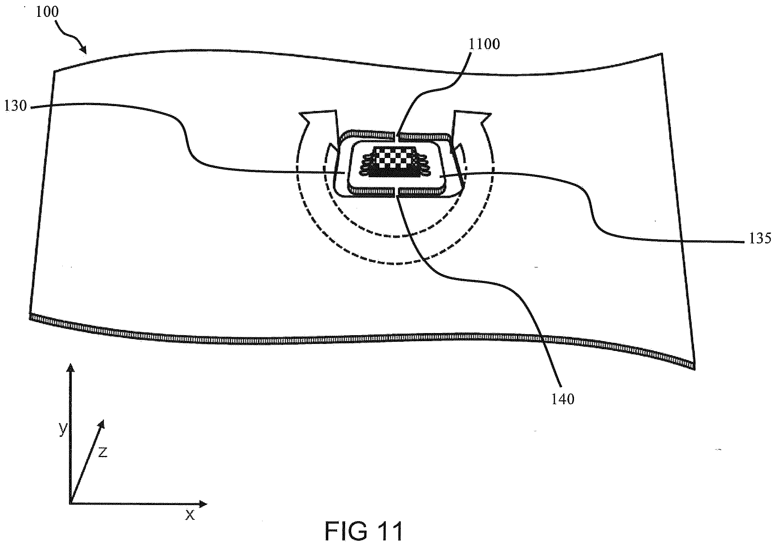

**Fig. 11** zeigt eine schematische Darstellung einer Leiterplattenvorrichtung 100 gemäß einem Ausführungsbeispiel. Dabei kann es sich um eine der anhand einer der vorangegangenen Figuren beschriebenen Leiterplattenvorrichtungen 100 handeln, mit dem Unterschied, dass der Kontaktbereich zumindest einen weiteren Steg 1100 mit einem weiteren Übergangsabschnitt zum Restbereich zum Verbinden des Kontaktbereichs mit dem Restbereich aufweist.

Der weitere Steg 1100 erstreckt sich gemäß diesem Ausführungsbeispiel von einer dem Steg 140 gegenüberliegenden Seite des Plättchens 135 weg und verbindet gemäß diesem Ausführungsbeispiel den Kontaktbereich mit dem Restbereich. Der Steg 140 und der weitere Steg 110 sind gemäß diesem Ausführungsbeispiel auf einer Achse liegend angeordnet. Eine Erstreckungslänge des Stegs 140 und/oder des weiteren Stegs 1100 entspricht gemäß diesem Ausführungsbeispiel im Wesentlichen einer Breite des Freischnitts 130. Gemäß diesem Ausführungsbeispiel ist eine Breite der Stege 140, 1100 kleiner als die Erstreckungslänge der Stege 140, 1100. Der Freischnitt 130 weist gemäß diesem Ausführungsbeispiel zwei Freischnittabschnitte auf, welche in Form von einander zugewandten C-förmigen Abschnitten ausgeformt sind. Die zwei Stege 140, 1100 trennen die zwei Freischnittabschnitte voneinander. Der Kontaktbereich oder zumindest das Plättchen 135 ist gemäß diesem Ausführungsbeispiel von geometrischen Verspannungen der Leiterplatte weitgehend entkoppelt und drehweich um die z-Achse.

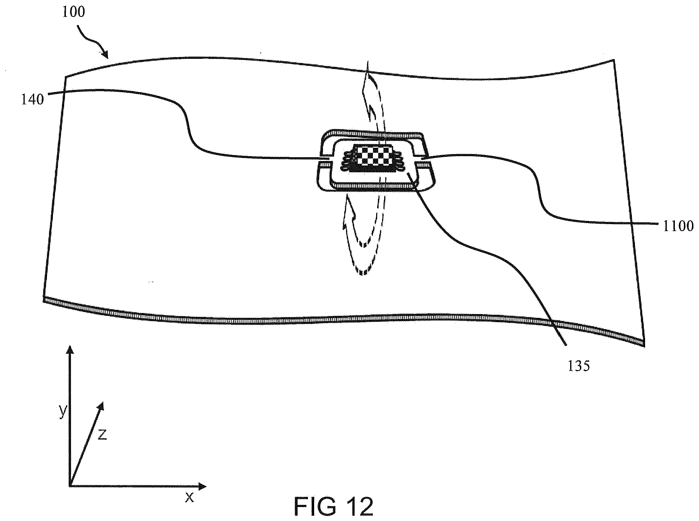

**Fig. 12** zeigt eine schematische Darstellung einer Leiterplattenvorrichtung 100 gemäß einem Ausführungsbeispiel. Dabei kann es sich um die anhand von Fig. 11 beschriebene Leiterplattenvorrichtung 100 handeln, mit dem Unterschied, dass die zwei Stege 140, 1100 gemäß diesem Ausführungsbeispiel um 90° verschoben angeordnet sind, sodass der Kontaktbereich oder zumindest das Plättchen 135 gemäß diesem Ausführungsbeispiel von geometrischen Verspannungen der Leiterplatte weitgehend entkoppelt und drehweich um die x-Achse ist. Zudem entspricht gemäß diesem Ausführungsbeispiel eine Breite der Stege 140, 1100 einer Erstreckungslänge der Stege 140, 1100.

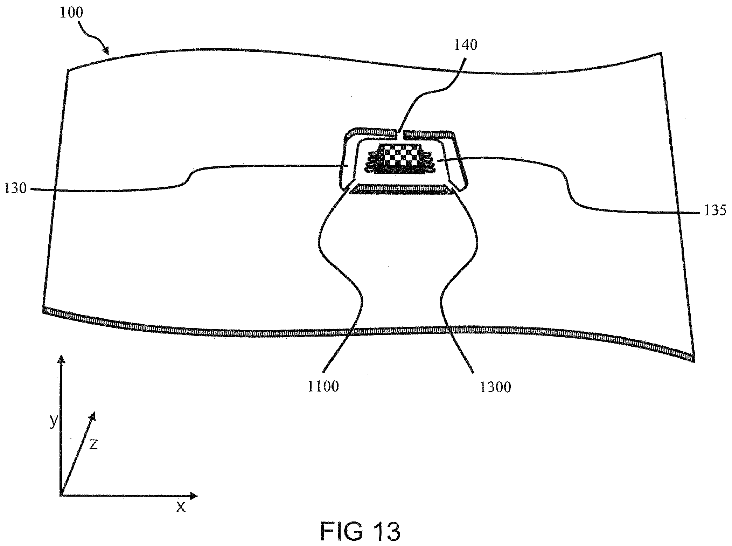

**Fig. 13** zeigt eine schematische Darstellung einer Leiterplattenvorrichtung 100 gemäß einem Ausführungsbeispiel. Dabei kann es sich um eine ähnlich zu der anhand von Fig. 11 beschriebenen Leiterplattenvorrichtung handeln, mit dem Unterschied, dass der Kontaktbereich über drei Stege 140, 1100, 1300 mit dem Restbereich verbunden ist.

Das Plättchen 135 des Kontaktbereichs ist rechteckig ausgeformt. Der Steg 140 ist mittig mit einer Längsseite des Plättchens 135 und der weitere Steg 1100 und der zusätzliche Steg 1300 sind mit Ecken einer der Längsseite gegenüberliegenden weiteren Längsseite des Plättchens 135 verbunden.

Gemäß diesem Ausführungsbeispiel sind der weitere Steg 1100 und der zusätzliche Steg 1300 schräg gegenüber dem Steg 140 verlaufend angeordnet. Gemäß diesem Ausführungsbeispiel erstrecken sich der weitere Steg 1100 und der zusätzliche Steg 1300 jeweils von einem Eckbereich des rechteckigen Plättchens 135 weg. Der Freischnitt 130 weist gemäß diesem Ausführungsbeispiel drei Freischnittabschnitte auf, welche in Form von zwei L-förmigen Abschnitten und einem geraden Abschnitt ausgeformt sind. Die drei Stege 140, 1100, 1300 trennen die drei Freischnittabschnitte voneinander. Der Kontaktbereich oder zumindest das Plättchen 135 ist gemäß diesem Ausführungsbeispiel von geometrischen Verspannungen der Leiterplatte weitgehend entkoppelt, aber ansonsten relativ steif mit der Leiterplatte verbunden.

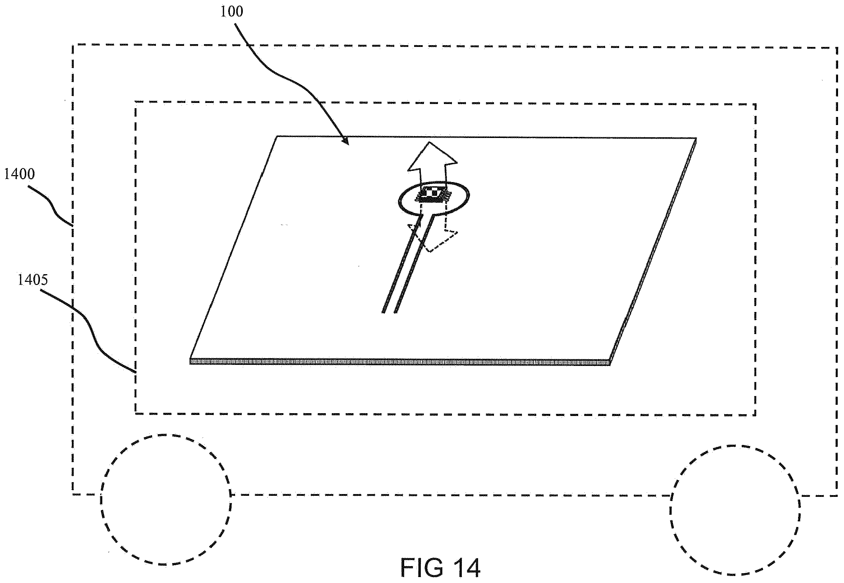

**Fig. 14** zeigt eine schematische Darstellung eines Fahrzeugs 1400 mit einer Leiterplattenvorrichtung 100 gemäß einem Ausführungsbeispiel. Dabei kann es sich um eine der anhand einer der vorangegangenen Figuren beschriebenen Leiterplattenvorrichtungen 100 handeln. Die Leiterplattenvorrichtung 100 ist gemäß diesem Ausführungsbeispiel lediglich beispielhaft Teil eines Fahrzeugsteuergeräts 1405 des Fahrzeugs 1400. Das Fahrzeugsteuergerät 1405 ist gemäß diesem Ausführungsbeispiel dazu ausgebildet, um eine Fahrzeugfunktion des Fahrzeugs 1400 zu steuern oder zu regeln.

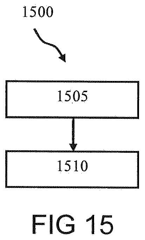

**Fig. 15** zeigt ein Ablaufdiagramm eines Verfahrens 1500 zum Herstellen einer Leiterplattenvorrichtung gemäß einem Ausführungsbeispiel. Dabei kann es sich um eine der anhand einer der vorangegangenen Figuren beschriebenen Leiterplattenvorrichtungen handeln.

Das Verfahren 1500 umfasst einen Schritt 1505 des Bereitstellens und einen Schritt 1510 des Erzeugens. Im Schritt 1505 des Bereitstellens wird eine Leiterplatte mit zumindest einem Kontaktbereich mit einem Kontaktelement zum elektrischen Kontaktieren eines Bauteils bereitgestellt. Im Schritt 1510 des Erzeugens wird ein den Kontaktbereich zumindest abschnittsweise von einem Restbereich der Leiterplatte freistellender Freischnitt erzeugt, der dazu ausgeformt ist, um im Betrieb der Leiterplattenvorrichtung ein Entkoppeln des Kontaktbereichs von dem Restbereich der Leiterplatte bezüglich zumindest einer Bewegungsrichtung des Kontaktbereichs oder des Restbereichs zu ermöglichen.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

### BEZUGSZEICHENLISTE

- 100: Leiterplattenvorrichtung
- 105: Leiterplatte
- 110: Kontaktbereich
- 115: Kontaktelement
- 120: Bauteil
- 125: Restbereich
- 130: Freischnitt
- 135: Plättchen
- 140: Steg
- 145: Übergangsabschnitt

- 200: Materialschwächung
- 205: Ausschnitt

- 300: Stegabschnitt

- 400: weiterer Ausschnitt

- 600: Dämpfungsmasse
- 605: weiterer Kontaktbereich

- 1100: weiterer Steg

- 1300: zusätzlicher Steg

- 1400: Fahrzeug
- 1405: Fahrzeugsteuergerät

- 1500: Verfahren zum Herstellen einer Leiterplattenvorrichtung
- 1505: Schritt des Bereitstellens
- 1510: Schritt des Erzeugens

## Patentansprüche

1. Leiterplattenvorrichtung (100), die die folgenden Merkmale aufweist:
eine Leiterplatte (105) mit zumindest einem Kontaktbereich (110) mit einem Kontaktelement (115) zum elektrischen Kontaktieren eines Bauteils (120) und einem den Kontaktbereich (110) zumindest abschnittsweise von einem Restbereich (125) der Leiterplatte (105) freistellenden Freischnitt (130), der dazu ausgeformt ist, um im Betrieb der Leiterplattenvorrichtung (100) ein Entkoppeln des Kontaktbereichs (110) von dem Restbereich (125) der Leiterplatte (105) bezüglich zumindest einer Bewegungsrichtung des Kontaktbereichs (110) oder des Restbereichs (125) zu ermöglichen.

2. Leiterplattenvorrichtung (100) gemäß Anspruch 1, mit dem Bauteil (120), das an dem Kontaktelement (115) elektrisch kontaktiert ist, insbesondere wobei das Bauteil (120) eine Sensoreinrichtung mit zumindest einem Sensor oder ein Aktor oder Stecker oder eine integrierte Schaltung ist.

3. Leiterplattenvorrichtung (100) gemäß einem der vorangegangenen Ansprüche, bei der der Freischnitt (130) dazu ausgeformt ist, um im Betrieb der Leiterplattenvorrichtung (100) ein Entkoppeln des Kontaktbereichs (110) von dem Restbereich (125) bezüglich zumindest einer Bewegungsrichtung auf einer x-Achse und/oder einer y-Achse und/oder einer z-Achse des Kontaktbereichs (110) oder des Restbereichs (125) zu ermöglichen.

4. Leiterplattenvorrichtung (100) gemäß einem der vorangegangenen Ansprüche, bei der der Kontaktbereich (110) ein Plättchen (135) und zumindest einen Steg (140) mit einem Übergangsabschnitt (145) zum Restbereich (125) zum Verbinden des Kontaktbereichs (110) mit dem Restbereich (125) aufweist.

5. Leiterplattenvorrichtung (100) gemäß Anspruch 4, bei der der Freischnitt (130) mit Ausnahme des Übergangsabschnitts (145) um den Kontaktbereich (110) herum verläuft.

6. Leiterplattenvorrichtung (100) gemäß einem der Ansprüche 4 bis 5, bei der eine Erstreckungslänge des Stegs (140) länger ist, als ein Durchmesser des Plättchens (135).

7. Leiterplattenvorrichtung (100) gemäß einem der Ansprüche 4 bis 5, bei der eine Erstreckungslänge des Stegs (140) im Wesentlichen einer Breite des Freischnitts (130) entspricht.

8. Leiterplattenvorrichtung (100) gemäß einem der Ansprüche 4 bis 7, bei der der Steg (140) zumindest abschnittsweise gerade und/oder konkav und/oder zumindest eine Windung aufweisend ausgeformt ist.

9. Leiterplattenvorrichtung (100) gemäß einem der vorangegangenen Ansprüche, bei der der Steg (140) eine Materialschwächung (200) aufweist.

10. Leiterplattenvorrichtung (100) gemäß einem der vorangegangenen Ansprüche, bei der der Kontaktbereich (110) zumindest einen weiteren Steg (1100) mit einem weiteren Übergangsabschnitt zum Restbereich (125) zum Verbinden des Kontaktbereichs (110) mit dem Restbereich (125) aufweist.

11. Leiterplattenvorrichtung (100) gemäß einem der vorangegangenen Ansprüche, bei der sich der weitere Steg (1100) von einer dem Steg (140) gegenüberliegenden Seite des Plättchens (135) weg erstreckt.

12. Leiterplattenvorrichtung (100) gemäß einem der Ansprüche 10 bis 11, bei der der Kontaktbereich (110) zumindest einen zusätzlichen Steg (1300) mit einem zusätzlichen Übergangsabschnitt zum Restbereich (125) zum Verbinden des Kontaktbereichs (110) mit dem Restbereich (125) aufweist.

13. Leiterplattenvorrichtung (100) gemäß einem der vorangegangenen Ansprüche, mit zumindest einer an zumindest einem Freischnittabschnitt des Freischnitts (130) angebrachten Dämpfungsmasse (600).

14. Leiterplattenvorrichtung (100) gemäß einem der vorangegangenen Ansprüche, bei der der Freischnitt (130) gefräst, lasergeschnitten, wasserstrahlgeschnitten, gestanzt und/oder gesägt ausgeformt ist.

15. Verfahren (1500) zum Herstellen einer Leiterplattenvorrichtung (100), wobei das Verfahren (1500) die folgenden Schritte umfasst:
Bereitstellen (1505) einer Leiterplatte (105) mit zumindest einem Kontaktbereich (110) mit einem Kontaktelement (115) zum elektrischen Kontaktieren eines Bauteils (120); und
Erzeugen (1510) eines den Kontaktbereich (110) zumindest abschnittsweise von einem Restbereich (125) der Leiterplatte (105) freistellenden Freischnitts (130), der dazu ausgeformt ist, um im Betrieb der Leiterplattenvorrichtung (100) ein Entkoppeln des Kontaktbereichs (110) von dem Restbereich (125) der Leiterplatte (105) bezüglich zumindest einer Bewegungsrichtung des Kontaktbereichs (110) oder des Restbereichs (125) zu ermöglichen.
